# EUROPÄISCHE PATENTANMELDUNG

(11) **EP 0 582 197 A2**
(43) Veröffentlichungstag der Anmeldung: **09.02.1994**
(21) Anmeldenummer: 93112070.3
(22) Anmeldetag: 28.07.1993
(51) Int. Cl.: D03D 1/00, D03D 15/00, H05K 1/03, B29C 67/14

(54) **Basismaterial und Prepreg zur Herstellung von Leiterplatten**

(30) Priorität: 07.08.1992 DE 4226208
(71) Anmelder: Siemens Nixdorf Informationssysteme Aktiengesellschaft, D-33102 Paderborn (DE)
(72) Erfinder: Neumann, Rudolf, Dipl.-Ing., D-86830 Schwabmünchen (DE)
(74) Vertreter: Fuchs, Franz-Josef, Dr.-Ing.

(57) **Zusammenfassung**

Die Erfindung bezieht sich auf Basismaterialien und Prepregs aus Epoxidharzglasfasergewebe zur Herstellung von Leiterplatten. Die Dimensionsstabilität von Basismaterial und Prepreg ist je nach Typ unterschiedlich. Diese Unterschiedlichkeit wird durch Temperprozesse über den Glasumwandlungspunkt und Vorhaltewerte bei den Druckwerkzeugen zu kompensieren versucht. Durch die Erfindung soll die Dimensionsstabilität derartiger Materialien verbessert werden. Durch die Verwendung von unidirektionalen Geweben, bei denene das Verhältnis der Glasstränge in Kett- und Schußrichtung oder umgekehrt größer 70:30 und/oder das Verhältnis der Garngewichte in Kett- und Schußrichtung oder umgekehrt größer 1,5:1 beträgt, und/oder als Webart Satinbindung realisiert wird, wird eine deutliche Verbesserung der Dimensionsstabilität bei nur geringfügig erhöhten Kosten erzielt.

## Beschreibung

Basismaterialien und Prepregs zur Herstellung von Leiterplatten haben je nach Verwendung ihrer Grundbestandteile und Herstellungsart ein unterschiedliches Verhalten bezüglich ihrer Dimensionsstabilität. Bisher wird versucht, das unterschiedliche Dimensionsverhalten durch Temperprozesse über den Glasumwandlungspunkt und Vorhaltewerte bei den Druckwerkzeugen zu kompensieren. Weiter werden die Leiterplatten nach dem Verpressen meist geröntgt, um so das Dimensionsverhalten des Laminates zu ermitteln und gegebenenfalls korrigierend eingreifen zu können. Trotz dieser aufwendigen Überwachung ist das Streuverhalten nach dem Verpressen und während der Fertigungsprozesse so groß, daß besonders bei feinstrukturierten Layouts zunehmend Proble me, z.B. bei der Plazierung der Bauteile auftreten. Es gibt auch Materialien, bei denen Harzsysteme mit günstigerem Dimensionsstabilitätsverhalten verwendet werden, die jedoch einen wesentlich höheren Preis haben, als die üblicherweise verwendeten.

Aufgabe der vorliegenden Erfindung ist es daher, ein Basismaterial und Prepregs mit gegenüber den bekannten Materialien verbesserter Dimensionsstabilität, jedoch in der gleichen Preislage zu schaffen.

Zur Lösung dieser Aufgabe wird zur Herstellung von Basismaterial und Prepreg unidirektionales Gewebe verwendet, bei dem das Verhältnis der Glasstränge in Kett- und Schußrichtung oder umgekehrt größer 70:30 und/oder das Verhältnis der Garngewichte in Kett- und Schußrichtung oder umgekehrt größer 1,5:1 beträgt und/oder Satinbindung als Webart realisiert ist.

Die Satinbindung allein bewirkt schon eine Bevorzugung einer Richtung hinsichtlich Anzahl bzw. Gewicht der Glasböden, weil gegenüber der üblichen Leinwandbindung mehrere Fäden in einer Vorzugsrichtung von einem Querfaden umwoben werden.

Durch diese Maßnahmen wird die Dimensionsstabilität in der Ebene und quer zur Leiterplatte deutlich verbessert, bei nur geringfügig höheren Kosten. Die Reduzierung des Laminatverzuges verhält sich dabei proportional zum Anteil von unidirektionalen Prepregs und/oder Basismaterialien in einem Laminat. Bei vollständigem Ersatz der üblichen Prepregs und/oder Basismaterialien zur Herstellung von mehrlagigen Leiterplatten wird praktisch kein Verzug mehr festgestellt und die Biegesteifigkeit wird ebenfalls deutlich erhöht.

## Patentansprüche

1. Basismaterial und Prepreg aus Epoxidharzglasfasergewebe zur Herstellung von Leiterplatten,
**gekennzeichnet** durch die Verwendung von unidirektionalen Geweben, bei denen das Verhältnis der Glasstränge in Kett- und Schußrichtung oder umgekehrt größer 70:30 und/oder das Verhältnis der Garngewichte in Kett- und Schußrichtung oder umgekehrt größer 1,5:1 beträgt und/oder Satinbindung als Webart realisiert wird.
